# EUROPEAN PATENT APPLICATION

(11) **EP 1 667 323 A1**
(43) Date of publication of application: **07.06.2006**
(21) Application number: 04773394.4
(22) Date of filing: 17.09.2004
(51) Int. Cl.: H03H 9/24, H03H 3/007

(54) **MICRO ELECTRIC MACHINE SYSTEM RESONATOR, DRIVE METHOD THEREOF, MANUFACTURING METHOD THEREOF, AND FREQUENCY FILTER**

(30) Priority: 19.09.2003 JP 2003327496; 25.02.2004 JP 2004049133
(71) Applicant: SONY CORPORATION, Tokyo 141-0001 (JP)
(72) Inventor: NANIWADA, Koji, c/o SONY CORPORATION, Tokyo (JP)
(74) Representative: Müller - Hoffmann & Partner
(86) International application number: PCT/JP2004/014010
(87) International publication number: WO 2005/029700

(57) **Abstract**

The phases of outputs are made different by 180° to allow unbalanced inputs to be output as balanced outputs.

A MEMS resonator (101) has an input electrode (111) for inputting a signal, output electrodes (first output electrode(112),second output electrode(113))for outputting balanced output signals from unbalanced input signals, and an oscillator facing the input electrode (111), first output electrode (112) and second output electrode (113) via a space (121), wherein the first output electrode (112) is disposed at a position having a phase different by 180° from the phase of the input electrode (111) and the second output electrode (113) is disposed at a position having the same phase as that of the input electrode (111).

## Description

### Technical Field

The present invention relates to a resonator of microelectromechanical systems easily outputs balanced signals, its driving method and a frequency filter.

### Background Art

With the development of information communication technologies, the number of devices utilizing networks has recently increased rapidly, and there are high demands for wireless network technologies from the standpoint of usage convenience.

An RF (radio frequency) front end module used in wireless communications has a semiconductor chip as well as relatively large size components such as anRF filter, a surface acoustic wave (SAW) filter and a dielectric filter for an IF (intermediate frequency) filter. The existence of these components has hindered compactness and low cost of an RF front end. A present demand is to incorporate these filter functions into a semiconductor chip.

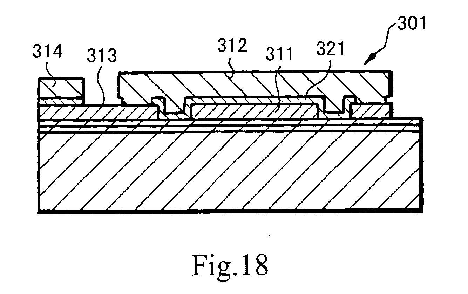

Research institutes including the University of Michigan have proposed to use a micro oscillator formed by utilizing semiconductor processes as an IF (intermediate frequency) filter and an RF (radio frequency) filter among wireless communication devices, because the micro oscillator has characteristics such as having a small device occupying area, being able to realize a high Q value, and being able to be integrated with other semiconductor devices (for example, refer to Non-Patent Document 1 ("High-Q HF Microelectromechanical Filters" by Frank D. Bonnon III, et al, IEEE (The Institute of Electrical and Electronics Engineers) JOURNAL OF SOLID-STATE CIRCUITS, VOL. 35, NO. 4 APRIL, 2000, p. 512 - 526) . Atypical example of this structure will be described with reference to an outline structure cross sectional view of Fig. 18.

As shown in Fig. 18, a micro oscillator 301 has the following structure. An oscillator electrode 312 is disposed above an output electrode 311 mounted on a substrate 310 with a space 321 being involved. The oscillator electrode 312 is connected to an input electrode 514 via an electrode 313.

Next, the operation of the micro oscillator will be described below. As a voltage at a specific frequency is applied to the input electrode 313, a beam (oscillation portion) of the oscillator electrode 312 mounted above the output electrode 311 via the space 321 oscillates at a characteristic frequency so that the capacitance of a capacitor constituted of the space between the output electrode 311 and beam (oscillation portion) changes, and this change is output as a voltage from the output electrode 311 (for example, refer to Non-Patent Document 1).

However, resonance frequencies of micro oscillators proposed and verified heretofore do not exceed 200 MHz at a maximum, and it is difficult to provide a filter of a GHz range by conventional surface acoustic waves (SAW) or thin film acoustic waves (FBAR), with a high Q value characteristic to micro oscillators in a GHz band frequency range.

Presently, there is a tendency that a resonance peak of an output signal in a high frequency range becomes generally small. In order to obtain good filter characteristics, it is necessary to improve an SN ratio of the resonance peak. According to the document (an example of a Disk type) of the University of Michigan (for example, refer to Non-Patent Document 1) , noise components in an output signal are generated by a signal directly passing through a parasitic capacitor formed between input/output electrodes, and in order to reduce this signal, an oscillator electrode applied with a direct current (DC) is disposed between input and output electrodes to thereby reduce the noise components.

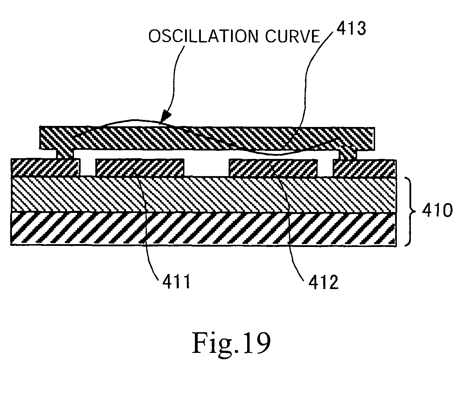

In order to obtain a sufficient output signal of a Disk type oscillator, a DC voltage over 30 V is required so that a practical structure is desired to be a beam type structure using a doubly-supported beam. If the noise component reduction method is adopted to the beam type structure, the electrode layout such as shown in Fig. 19 is used.

As shown in Fig. 19, on a substrate 410 having a laminated film of a silicon oxide film and a silicon nitride film formed on a silicon substrate, an input electrode 411 and an output electrode 412 are disposed in parallel and spaced apart from each other. Above the input and output electrodes, a beam type oscillator 413 is disposed traversing the input and output electrodes 411 and 412 with a small space 421 being interposed therebetween. A curve shown in the drawing is an oscillation curve of the beam type oscillator 413.

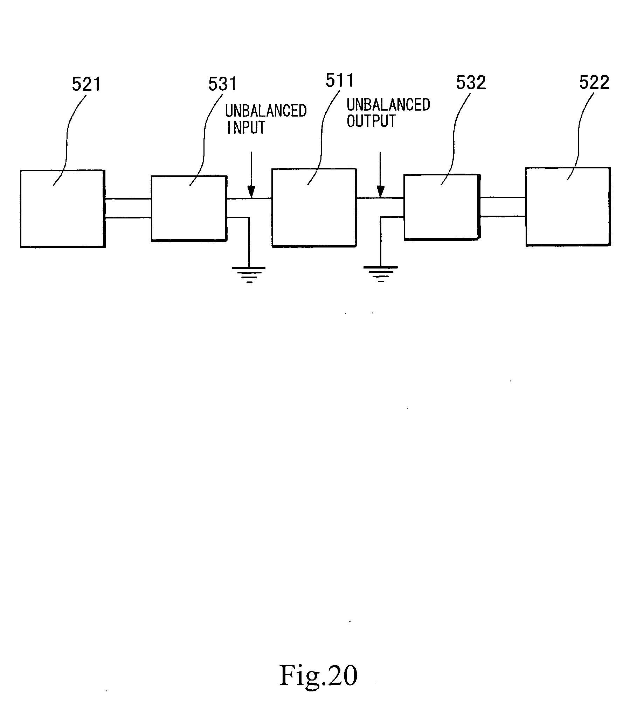

The oscillator 413 of the resonator of this type provides secondary mode oscillations, unbalanced input and unbalanced outputs. If the resonator of this type is used for a balanced input frequency filter, as shown in Fig. 20 it is necessary to connect a balun device 531 that changes output signals (balanced inputs) from a previous stage device (e.g., an integrated circuit) 521 to unbalanced inputs for a frequency filter 511 and a balun device 532 that is connected at an output stage of the frequency filter 511 and changes unbalanced outputs from the frequency filter 511 to balanced outputs. In this manner, a balanced input signal can be input to a subsequent stage device (e.g., an integrated circuit) 522 connected to the frequency filter 511.

A problem to be solved resides in that outputs of a conventional resonator in microelectromechanical systems (hereinafter described as an MEMS resonator) are unbalanced. Moreover, a frequency filter using a resonator with unbalanced inputs and balanced outputs is needed for practical usage. If outputs are unbalanced, a balun device for changing unbalance to balance is required additionally.

A conventional resonator in microelectromechanical systems is a device with unbalanced inputs and unbalanced outputs. The main trend in present communication apparatus is balanced signals in an integrated circuit. In order to use a conventional MEMS resonator, for example, a balance-unbalance (Balun) converter is required for the application to IF filters or the like. This means an increase in cost and size, resulting in difficulty of adopting MEMS resonators.

### Disclosure of the Invention

In a resonator in a microelectromechanical having: an input electrode for inputting a signal; an output electrode for outputting a signal; and an oscillator facing the input electrode and the output electrode via a space, the most important characteristic of the resonator in a microelectromechanical system of the present invention is that the output electrode has an electrode for outputting a balanced signal.

In a manufacture method for a resonator in a microelectromechanical system, the resonator having: input electrodes for inputting signals; output electrodes for outputting signals; and an oscillator facing the input electrodes and the output electrodes via a space, the most important characteristic of the manufacture method for a resonator in a microelectromechanical system of the present invention is to include the steps of: forming the input electrodes and the output electrodes at the same time; forming a first input electrode and a second input electrode as the input electrodes; forming a first output electrode and a second output electrode as the output electrodes; disposing the first input electrode and the first output electrode in such a manner that amplitude phases of the oscillator at positions of the first input electrode and the first output electrode become a same phase; and disposing and the second input electrode and the second output electrode in such a manner that amplitude phases of the oscillator at positions of the second input electrode and the second output electrode become a same phase and different by 180° from the phase of the oscillator.

In a driving method for a resonator in a microelectromechanical system, the resonator having: an input electrode for inputting a signal; output electrodes for outputting signals; and an oscillator facing the input electrode and the output electrodes via a space, the most important characteristic of the driving method for a resonator in a microelectromechanical system of the present invention is that unbalanced signals are input and balanced signals are output.

In a resonator in a microelectromechanical system, the resonator having: an input electrode for inputting a signal; output electrodes for outputting signals; and an oscillator facing the input electrode and the output electrodes via a space, the most important characteristic of a frequency filter of the present invention is that the resonator has the output electrodes including electrodes for inputting unbalanced signals and outputting balanced signals.

### Brief Description of Drawings

Fig. 1 is an outline structure cross sectional view showing a first embodiment of a MEMS resonator of the present invention.
Fig. 2 is an oscillation curve showing an oscillation mode of an oscillator of the MEMS resonator shown in Fig. 1.
Figs. 3A to 3H are manufacture process cross sectional views illustrating an example of a manufacture method for a MEMS resonator of the present invention.
Fig. 4 is an outline structure circuit diagram using a filter of the present invention.
Fig. 5 is an outline structure cross sectional view showing a second embodiment of a MEMS resonator of the present invention.
Fig. 6 is an oscillation curve showing an oscillation mode of an oscillator of the MEMS resonator shown in Fig. 5.
Fig. 7 is a manufacture process cross sectional view illustrating an example of a manufacture method for the MEMS resonator of the second embodiment.
Fig. 8 is an outline structure cross sectional view showing a third embodiment of a MEMS resonator of the present invention.
Fig. 9 is an oscillation curve showing an oscillation mode of an oscillator of the MEMS resonator shown in Fig. 8.
Fig. 10 is a manufacture process cross sectional view illustrating an example of a manufacture method for the MEMS resonator of the third embodiment.
Figs. 11A and 11B are outline structure cross sectional views showing a fourth embodiment of a MEMS resonator of the present invention.
Fig. 12 is an oscillation curve showing an oscillation mode of an oscillator of the MEMS resonator shown in Fig. 11A.
Figs. 13A and 13B are outline structure cross sectional views showing a fifth embodiment of a MEMS resonator of the present invention.
Fig. 14 is an oscillation curve showing an oscillation mode of an oscillator of the MEMS resonator shown in Fig. 13A.
Fig. 15 is an outline structure cross sectional view showing a sixth embodiment of a MEMS resonator of the present invention.
Figs. 16A to 16H are manufacture process cross sectional views illustrating an example of amanufacturemethod for a MEMS resonator of the present invention.
Fig. 17 is a block diagram illustrating inputs and outputs of a filter of the present invention.
Fig. 18 is an outline structure cross sectional view of a conventional MEMS resonator.
Fig. 19 is an outline structure cross sectional view of a conventional MEMS resonator.
Fig. 20 is a block diagram illustrating inputs and outputs of a filter using a conventional MEMS resonator.

### Best Mode for Carrying Out the Invention

### [First Embodiment]

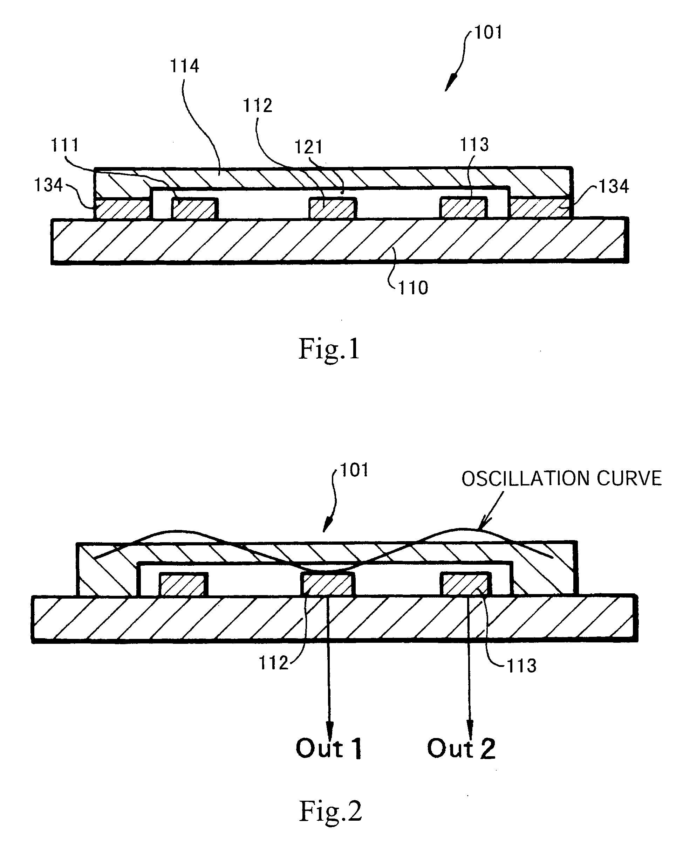

The first embodiment of a MEMS resonator 101 of the present invention will be described with reference to the outline structure cross sectional view of Fig. 1.

As shown in Fig. 1, on a substrate 110 having an insulating film (not shown) formed on the surface thereof, an input electrode 111 for inputting a signal, a first output electrode 112 and a second output electrode 113 for outputting signals are formed in parallel. In addition, the first output electrode 112 is disposed at apositionhaving a phase different by 180° from that of the input electrode 111, whereas the second output electrode 113 is disposed at a position having the same phase as that of the input electrode 111. Further, electrodes 134 of the resonator are disposed sandwiching the input electrode 111, first output electrode 112 and second output electrode 113. An oscillator 114 is formed above the input electrode 111, first output electrode 112 and second output electrode 113, facing these electrodes via a space 121 and being connected to the electrodes 134. The space 121 is formed having a distance of, for example, about 0.1 µm between the oscillator 114 and the input electrode 111, first output electrode 112 and second output electrode 113.

The oscillator 114 of the MEMS resonator 101 constructed as above oscillates in a third-order mode drawing an oscillation curve such as shown in Fig. 2. Therefore, the MEMS resonator 101 outputs a combined output of an output Out1 from the first output electrode 112 and an output Out2 from the second output electrode 113 having a phase different by 180° from that of the first output electrode 112, so that unbalanced outputs can be changed to balanced outputs.

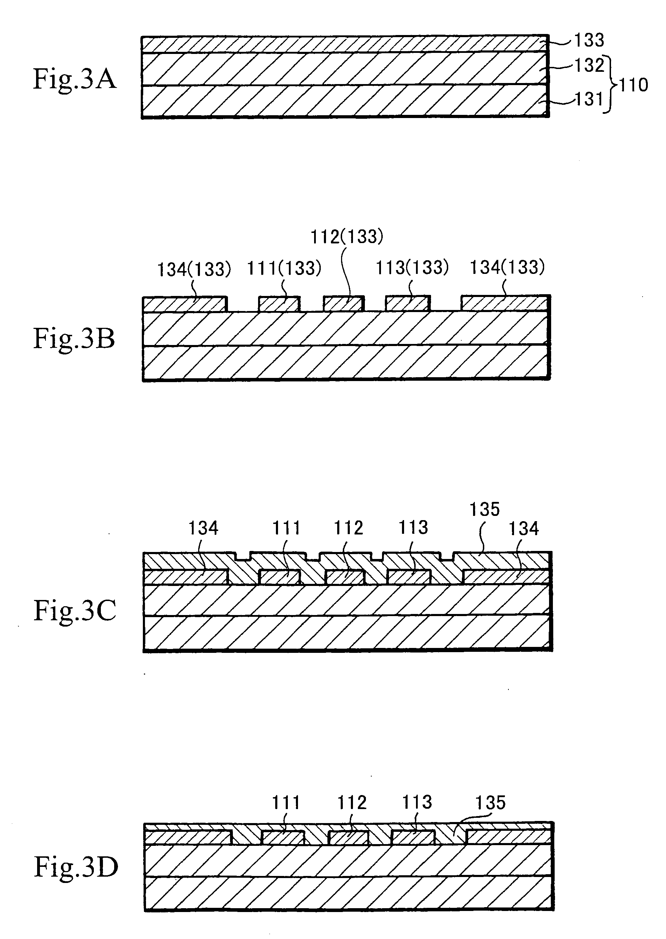

Next, an example of a manufacture method for the MEMS resonator 101 of the present invention will be described with reference to themanufactureprocess cross sectional views shown in Figs. 3A to 3H.

As shown in Fig. 3A, an insulating film 132 is formed on a semiconductor substrate 131. For example, the semiconductor substrate 131 is a silicon substrate and the insulating film 132 is a silicon nitride (SiN) film. The silicon nitride film has a thickness of, for example, 1 µm. Instead of the silicon nitride film, a laminated film of a silicon oxide film and a silicon nitride film may be used. In this manner, a substrate 110 is constituted of, for example, a silicon substrate as the semiconductor substrate 131 and the insulating film 132 formed on the semiconductor substrate. An electrode forming film 133 is formed on the insulating film 132. For example, the electrode forming film 133 is made of a polysilicon film and has a thickness of 0.5 µm.

Next, as shown in Fig. 3B, the electrode forming film 133 is processed into the forms of the input electrode and output electrodes by resist coating and lithography techniques to form a resist mask , and thereafter, by using the resist mask, the electrode forming film 133 is etched to form the input electrode 111, first output electrode 112 and second output electrode 113 . At the same time, the oscillator electrodes 134 are formed from the electrode forming film 133 . In this case, the first output electrode 112 is disposed at a position having a phase different by 180° from that of the input electrode 111, whereas the second output electrode 113 is disposed at a position having the same phase as that of the input electrode 111. Further, the oscillator electrodes 134 are formed sandwiching an electrode group including the input electrode 111, first output electrode 112 and second output electrode 113, and being spaced from the electrode group.

Next, as shown in Fig. 3C, a sacrificial layer 135 thicker than the input electrode 111 and output electrode 112 is formed covering the input electrode 111, first output electrode 112, second output electrode 113 and oscillator electrodes 134. For example, the sacrificial layer 135 is a silicon oxide film and has a thickness of 0.5 µm. It is sufficient if the sacrificial layer 135 is made of material which is selectively etched relative to the insulating film 132 and electrodes.

Next, as shown in Fig. 3D, the surface of the sacrificial layer 135 is planarized by chemical mechanical polishing. At this time, the sacrificial layer 135 is left thin on the input electrode 111, first output electrode 112 and second output electrode 113 . Since a thickness to be left determines a distance between an oscillator to be formed later and the input electrode 111, first output electrode 112 and second output electrode 113, the sacrificial layer 135 corresponding to the distance is to be left. For example, the sacrificial layer 135 having a thickness of 0.1 µm is left on the input electrode 111, first output electrode 112 and second output electrode 113.

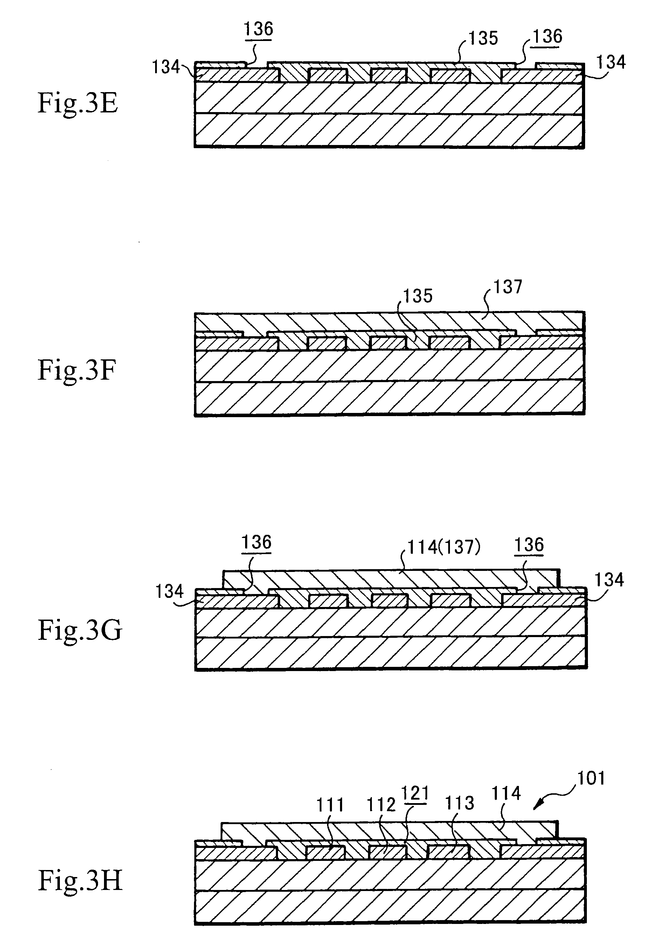

Next, as shown in Fig. 3E, an etching mask is formed by ordinary resist coating and lithograph techniques, and by using the etching mask, the sacrificial layer 135 is partially etched to form openings 136 exposing partial surfaces of the electrodes 134.

Next, as shown in Fig. 3F, an oscillator forming film 137 is formed on the whole surface of the sacrificial layer 135. For example, the oscillator forming film 137 is a polysilicon film and has a thickness of 0.5 µm.

Next, as shown in Fig. 3G, an etching mask is formed by ordinary resist coating and lithograph techniques, and by using the etching mask, the oscillator forming film 137 is etched to form a beam-like oscillator 114. The oscillator 114 is connected to the electrodes 134 via the openings 136.

Next, as shown in Fig. 3H, the sacrificial layer 135 (refer to Fig. 3G) is etched and removed by wet etching. Since the sacrificial layer 135 is made of silicon oxide in this example, hydrofluoric acid is used. Therefore, a space 121 is formed on both sides of each of the input electrode 111, first output electrode 112 and second output electrodes 113, and between the oscillator 114 and the input electrode 111, first output electrode 112 and second output electrodes 113. The space 121 has a distance of about 0.1 µm between the oscillator 114 and the input electrode 111, first output electrode 112 and second output electrodes 113 . In this manner, the MEMS resonator 101 is formed.

A method of forming each film by the above-described manufacture method may adopt CVD, sputtering, evaporation and the like. A thickness of each film is designed appropriately. If the uppermost surface of the insulating film 132 is made of silicon oxide and each electrode is made of polysilicon, the sacrificial layer 135 may be made of silicon nitride. In this case, hot phosphoric acid is used for wet-etching the sacrificial layer 135.

With the above-described manufacture method, the MEMS resonator 101 of the third-order mode capable of outputting balanced outputs from unbalanced inputs can be obtained.

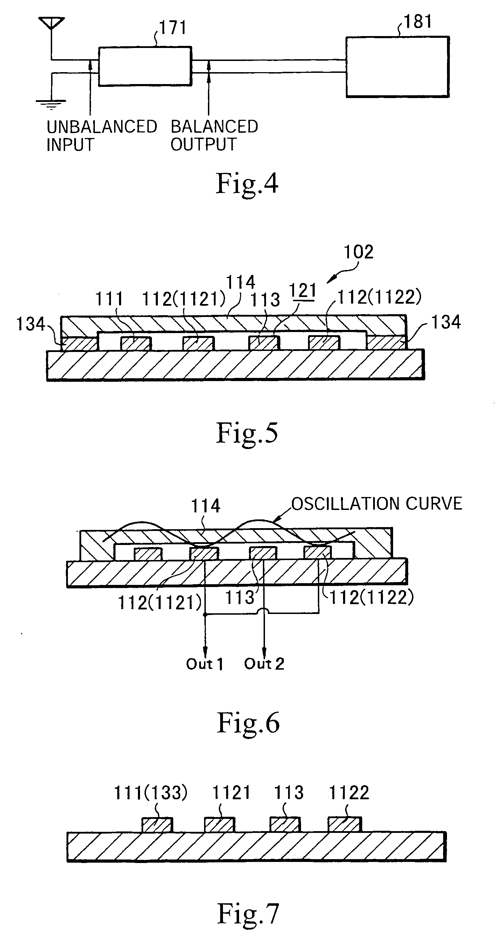

Next, an embodiment using the MEMS resonator 101 of the present invention as a frequency filterwill be described with reference to the outline structure circuit diagram shown in Fig. 4.

As described earlier, the MEMS resonator 101 of the present invention outputs balanced outputs from unbalanced inputs. Therefore, if the resonator 101 is used as the frequency filter, it is not necessary to use the balun device for changing unbalanced inputs to balanced outputs. More specifically, as shown in Fig. 4, a frequency filter 171 using the MEMS resonator 101 of the present invention outputs balanced outputs from unbalanced inputs. It is therefore possible to directly connect a previous stage integrated circuit 181 to the frequency filter 171.

### [Second Embodiment]

The second embodiment of a MEMS resonator of the present invention will be described with reference to the outline structure cross sectional view of Fig. 5. The MEMS resonator has a first output electrode disposed on both sides of the second output electrode.

As shown in Fig. 5, on a substrate 110 having an insulating film (not shown) formed on the surface thereof, an input electrode 111 for inputting a signal, a first output electrode 112 (1121), a second output electrode 113 and a first output electrode 112 (1122) for outputting signals are formed in parallel. In addition, the first output electrodes 112 are disposed at positions having a phase different by 180° from that of the input electrode 111, whereas the second output electrode 113 is disposed at a position having the same phase as that of the input electrode 111 and between the first output electrodes 1121 and 1122. Further, electrodes 134 of the resonator are disposed sandwiching the input electrode 111, first output electrodes 112 and second output electrode 113. An oscillator 114 is formed above the input electrode 111, first output electrodes 112 and second output electrode 113, facing these electrodes via a space 121 and being connected to the electrodes 134. The space 121 is formed having a distance of, for example, about 0.1 µm between the oscillator 114 and the input electrode 111, first output electrodes 112 and second output electrode 113.

The oscillator 114 of the MEMS resonator 102 constructed as above oscillates in a fourth-order mode drawing an oscillation curve such as shown in Fig. 6. Therefore, the MEMS resonator 102 outputs a combined output of outputs Out1 from the first output electrodes 112 (1121 and 1122) and an output Out2 from the second output electrode 113 having a phase different by 180° from that of the first output electrodes 112, so that unbalanced outputs can be changed to balanced outputs.

For a manufacture method for the MEMS resonator 2, in the manufacture method described with reference to Figs. 3A to 3H, an electrode forming film 133 is patterned in such a manner that the input electrode 111, first output electrode 1121, second output electrode 113 and first output electrode 122 are formed in parallel in this order as shown in Fig. 7. More specifically, the first output electrodes 1121 and 1122 are disposed at positions having a phase different by 180° from that of the input electrode 111, and the second output electrode 113 is disposed at a position having the same phase as that of the input electrode 111. Further, the second output electrode 113 is disposed between the first output electrodes 1121 and 1122. Furthermore, the oscillator electrodes 134 are formed sandwiching an electrode group including the input electrode 111, first output electrodes 1121 and 1122 and second output electrode 113. Other processes are similar to those of the manufacture method described with reference to Figs. 3A to 3H.

### [Third Embodiment]

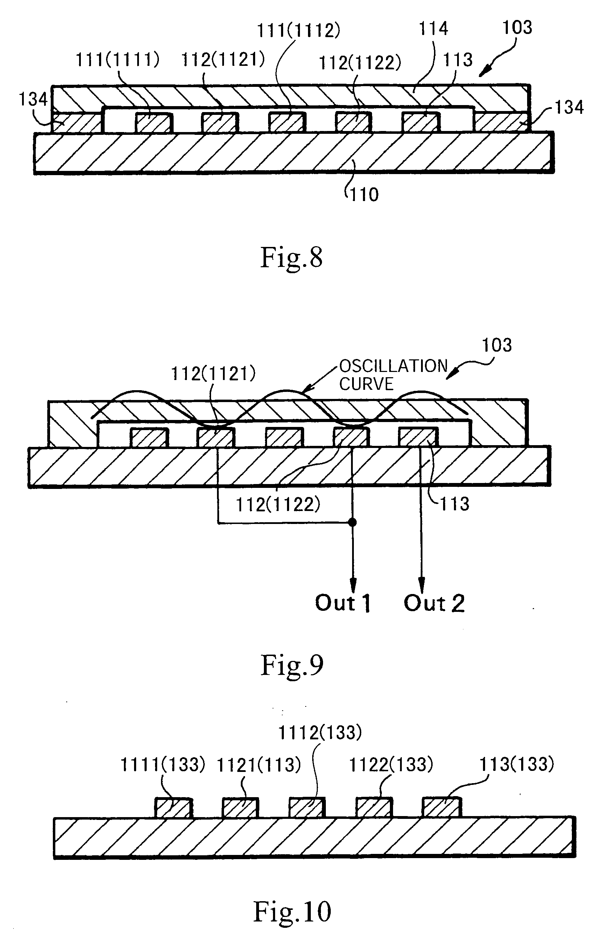

The third embodiment of a MEMS resonator of the present invention will be described with reference to the outline structure cross sectional view of Fig. 8. The MEMS resonator has an input electrode and a first output electrode disposed alternately.

As shown in Fig. 8, on a substrate 110 having an insulating film (not shown) formed on the surface thereof, an input electrode 111 (1111) for inputting a signal, a first output electrode 112 (1121) for outputting a signal, an input electrode 111 (1112) for inputting a signal having the same phase as that of the input electrode 1111, a first output electrode 112 (1122) for outputting a signal and a second output electrode 113 are formed inparallel in this order. In addition, the first output electrodes 112 are disposed at positions having a phase different by 180° from that of the input electrode 111, the input electrodes 1111 and 1112 and first output electrodes 1121 and 1122 are disposed alternately, and the second output electrode 113 is disposed on the opposite side of the input electrode 111 relative to the first output electrode 112 (1122) disposed at the last end of the layoutof the input electrodes 111 and first output electrodes 112, and at apositionhaving the samephase as that of the input electrode 111. Further, electrodes 134 of the resonator are formed sandwiching the input electrodes 111, first output electrodes 112 and second output electrode 113. An oscillator 114 is formed above the input electrodes 111, first output electrodes 112 and second output electrode 113, facing these electrodes via a space 121 and being connected to the electrodes 134. The space 121 is formed having a distance of, for example, about 0.1 µm between the oscillator 114 and the input electrodes 111, first output electrodes 112 and second output electrode 113.

The oscillator 114 of the MEMS resonator 103 constructed as above oscillates in a fifth-order mode drawing an oscillation curve such as shown in Fig. 10. Therefore, the resonator 103 outputs a combined output of outputs Out1 from the first output electrodes 112 (1121 and 1122) and an output Out2 from the second output electrode 113 having a phase different by 180° from that of the first output electrodes 112, so that unbalanced outputs can be changed to balanced outputs.

For a manufacture method for the MEMS resonator 103, in the manufacture method described with reference to Figs. 3A to 3H, an electrode forming film 133 is patterned in such a manner that the input electrode 1111, first output electrode 1121, input electrode 1112, first output electrode 1122 and second electrode 113 are formed in parallel in this order as shown in Fig. 10. More specifically, the input electrodes 1111 and 1112 are disposed at positions having the same phase, the first output electrodes 1121 and 1122 are disposed at positions having a phase different by 180° from that of the input electrodes 1111 and 1112, the input electrodes 1111 and 1112 and the first output electrodes 1121 and 1122 are disposed alternately, and the second output electrode 113 is disposed on the opposite side of the input electrode 1112 relative to the first output electrode 1122 disposed at the last end of the layout of the input electrodes 1111 and 1112 and first output electrodes 1121 and 1122, and at a position having the same phase as that of the input electrodes 1111 and 1112. Furthermore, the oscillator electrode 134 is formed sandwiching an electrode group including the input electrode 1111 and 1112 , first output electrodes 1121 and 1122 and second output electrode 113. Other processes are similar to those of the manufacture method described with reference to Figs. 3A to 3H.

Similar to the MEMS resonator 101, the MEMS resonators 102 and 103 can also be used as the frequency filter described with reference to Fig. 4.

In the first to third embodiments described above, each of the input electrode 111, first output electrode 112, second output electrode 113, electrodes 134 may be made of metal instead of polysilicon. For example, the metal may use material used as metal wirings of a semiconductor device, such as aluminum, gold, copper and tungsten.

In the resonator and its driving method in microelectromechanical systems of the present invention, since the output electrodes are provided which can output balanced outputs from unbalanced inputs, unbalanced inputs and balanced outputs are possible. Accordingly, the frequency filter of the present invention does not require the balun device which is required for an RF filter using a conventional beam type resonator. It is advantageous in that the circuit can be simplified and made compactat low cost.

In the first to third embodiments, the object of outputting balanced outputs from unbalanced inputs is realized by providing the electrodes of balanced outputs without using the balun device.

### [Fourth Embodiment]

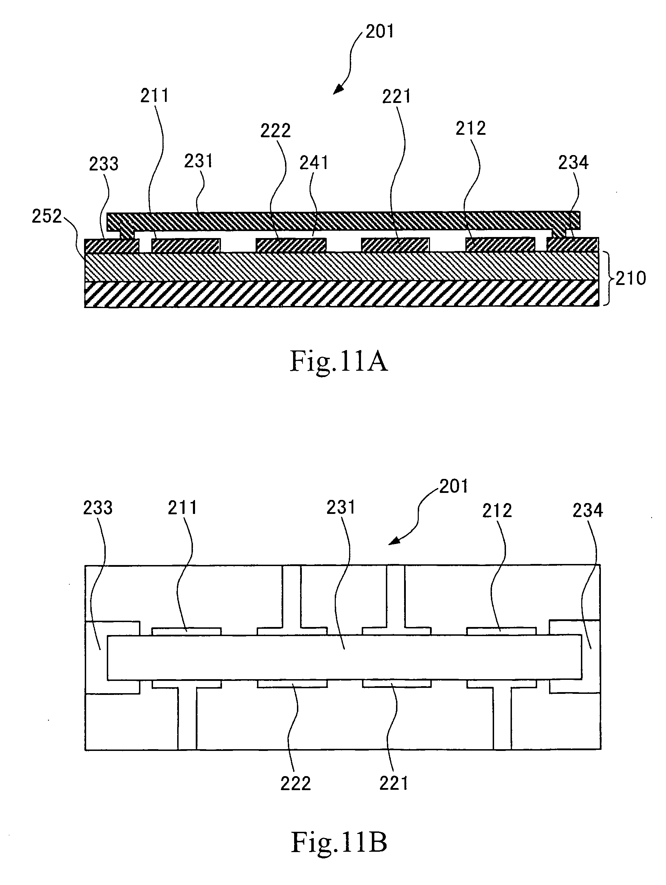

The fourth embodiment of a MEMS resonator 201 of the present invention will be described with reference to the outline structure cross sectional view of Fig. 11A and a plan layout diagram of Fig. 11B.

As shown in Figs. 11A and 11B, on a substrate 210 having an insulating film 252 formed on the surface thereof, a first input electrode 211 and a second input electrode 212 for inputting balanced signals and a first output electrode 221 and a first output electrode 221 for outputting balanced signals are disposed in parallel in the order of the first input electrode 211, second output electrode 222, first output electrode 221 and first input electrode 212, and at such positions as the amplitude phases of an oscillator 231 to be described later at the positions of the first input electrode 211 and first output electrode 221 become the same phase and the amplitude phases of the oscillator 231 at the positions of the second input electrode 212 and second output electrode 222 become the same phase and different by 180° from that of the oscillator 231 at the position of the first input electrode 211.

Electrodes 233 and 234 of the resonator are formed sandwiching the first input electrode 211, second output electrode 222, first output electrode 221 and second input electrode 212. The oscillator 231 is formed above the first input electrode 211, second output electrode 222, first output electrode 221 and second input electrode 212, facing these electrodes via a space 241 and being connected to the electrodes 233 and 234. The space 241 is formed having a distance of, for example, about 0.1 µm between the oscillator 231 and the first input electrode 211, second output electrode 222, first output electrode 221 and second input electrode 212.

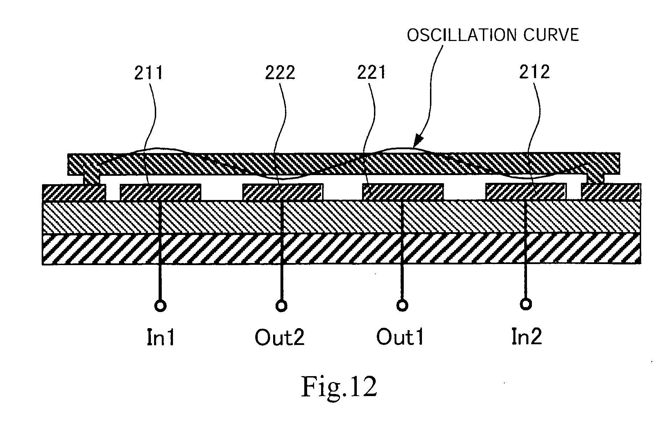

The oscillator 231 of the MEMS resonator 201 constructed as above oscillates in a third-order mode drawing an oscillation curve such as shown in Fig. 12. Therefore, the MEMS resonator 201 inputs a balanced signal from an input In1 to the first input electrode 211, and the input signal is output as a balanced signal from the first output electrode 221 to an output Out1. Similarly, a balanced signal is input from an input In2 to the second input electrode 212, and the input signal is output as a balanced signal from the second output electrode 222 to an output Out2. In this manner, a balanced input signal is output as a balanced output signal.

### [Fifth Embodiment]

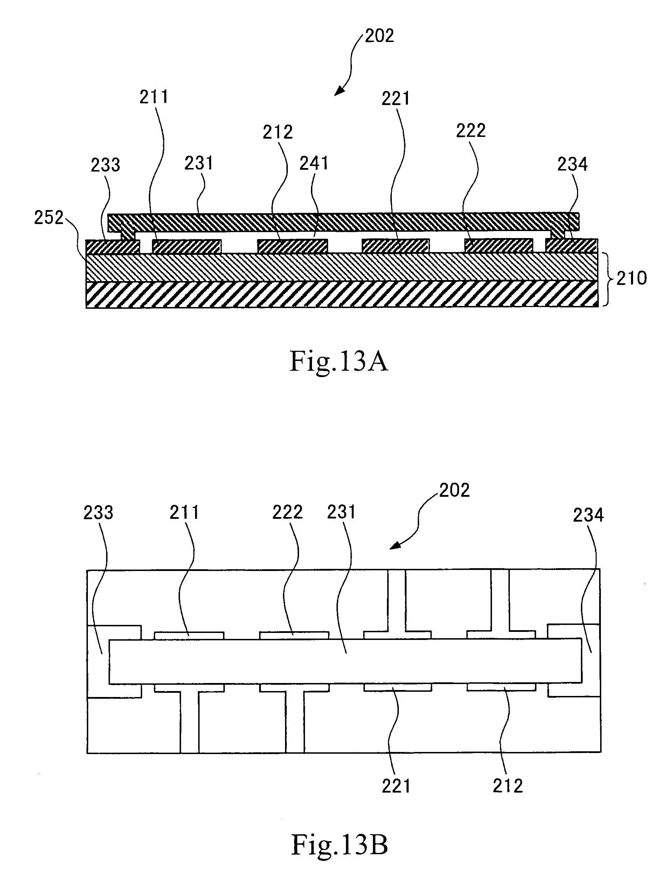

The fifth embodiment of a MEMS resonator 202 of the present invention will be described with reference to the outline structure cross sectional view of Fig. 13A and a plan layout diagram of Fig. 13B.

As shown in Figs. 13A and 13B, on a substrate 210 having an insulating film (not shown) formed on the surface thereof, a first input electrode 211 and a second input electrode 212 for inputting balanced signals and a first output electrode 221 and a second output electrode 222 for outputting balanced signals are disposed in parallel in the order of the first input electrode 211, second input electrode 212, first output electrode 221 and second output electrode 222, and at such positions as the amplitude phases of an oscillator 231 to be described later at the positions of the first input electrode 211 and first output electrode 221 become the same phase and the amplitude phases of the oscillator 231 at the positions of the second input electrode 212 and second output electrode 222 become the same phase and different by 180° from that of the oscillator 231 at the position of the first input electrode 211.

Electrodes 233 and 234 of the resonator are formed sandwiching the first input electrode 211, second input electrode 212, first output electrode 221 and second output electrode 222. The oscillator 231 is formed above the first input electrode 211, second input electrode 212, first output electrode 221 and second output electrode 222, facing these electrodes via a space 241 and being connected to the electrodes 233 and 234. The space 241 is formed having a distance of, for example, about 0.1 µm between the oscillator 231 and the first input electrode 211, second output electrode 222, first output electrode 221 and second input electrode 212.

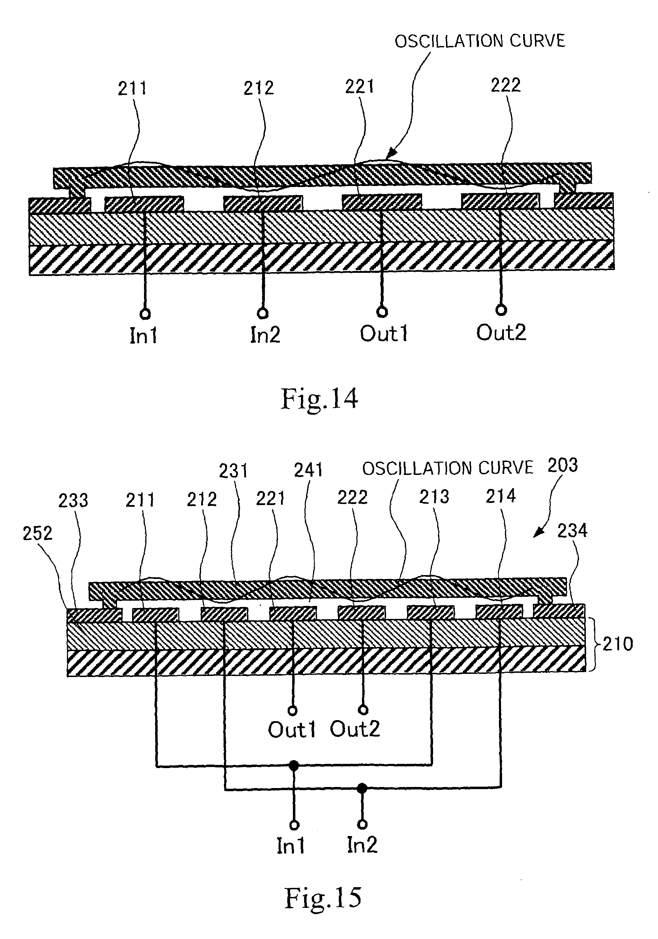

The oscillator 231 of the MEMS resonator 202 constructed as above oscillates in a third-order mode drawing an oscillation curve such as shown in Fig. 14. Therefore, the MEMS resonator 102 inputs a balanced signal from an input In1 to the first input electrode 211, the input signal is output as a balanced signal from the first output electrode 221 to an output Out1. Similarly, a balanced signal is input from an input In2 to the second input electrode 212, and the input signal is output as a balanced signal from the second output electrode 222 to an output Out2. In this manner, a balanced input signal is output as a balanced output signal.

### [Sixth Embodiment]

In the above-described fourth and fifth embodiments, the MEMS resonator in the fourth-order mode has been described. The MEMS resonator of the present invention can be made to oscillate in a 2n-th order mode (n is a natural number of 2 or larger). For example, an example of a MEMS resonator capable of vibrating in the sixth-order mode will be described with reference to the outline structure cross sectional view of Fig. 15.

As shown in Fig. 15, on a substrate 210 having an insulating film (not shown) formed on the surface thereof, a first input electrode 211, a second input electrode 212, a third input electrode 213 and a fourth input electrode 214 for inputting balanced signals and a first output electrode 221 and second output electrode 222 for outputting balanced signals are disposed in parallel in the order of the first input electrode 211, second input electrode 212, first output electrode 221, second output electrode 222, third input electrode 213 and fourth input electrode 214, and at such positions as the amplitude phases of an oscillator 231 to be described later at the positions of the first input electrode 211, first output electrode 221 and third input electrode 213 become the same phase and the amplitude phases of the oscillator 231 at the positions of the second input electrode 212, second output electrode 222 and fourth input electrode 214 become the same phase and different by 180° from that of the oscillator 231 at the position of the first input electrode 211.

Electrodes 233 and 234 of the resonator are formed sandwiching the first input electrode 211, second input electrode 212, third input electrode 213, fourth input electrode 214, first output electrode 221 and second output electrode 222. The oscillator 231 is formed above the first input electrode 211, second input electrode 212, third input electrode 213, fourth input electrode 214, first output electrode 221 and second output electrode 222, facing these electrodes via a space 241 and being connected to the electrodes 233 and 234. The space 241 is formed having a distance of, for example, about 0.1 µm between the oscillator 231 and the first input electrode 211, first input electrode 211, first output electrode 221, second output electrode 222, third input electrode 213 and fourth input electrode 214.

The oscillator 231 of the MEMS resonator 203 constructed as above oscillates in a sixth-order mode drawing an oscillation curve such as shown in Fig. 15. Therefore, the MEMS resonator 201 inputs a balanced signal from an input In1 to the first input electrode 211 and third input electrode 213, and the input signal is output as a balanced signal from the first output electrode 221 to an output Out1. Similarly, a balanced signal is input from an input In2 to the second input electrode 212 and fourth input electrode 214, and the input signal is output as a balanced signal from the second output electrode 222 to an output Out2. In this manner, a balanced input signal is output as a balanced output signal.

The layout positions of each input electrode (first input electrode, second input electrode, third input electrode,...) and each output electrode (first output electrode, second output electrode, third output electrode,...) of the MEMS resonator in the 2n-th (n is a natural number of 2 or larger) order oscillation mode are as follows.

The first input electrode is disposed at an odd number position among 2n, and the first output electrode for outputting a signal input to the first input electrode is disposed at an odd number position among 2n other than the position where the first input electrode is disposed. The second input electrode is disposed at an even number position among 2n, and the second output electrode for outputting a signal input to the second input electrode is disposed at an even number position among 2n other than the position where the second input electrode is disposed. In the case of the sixth-order mode or higher, an input electrode of the third input electrode and subsequent input electrodes (third input electrode, fourth input electrode, ...) is disposed at a vacant odd number position among 2n if the input electrode has the same phase as that of the first input electrode, or at a vacant even number position among 2n if the input electrode has the same phase as that of the second input electrode, and an output electrode of the third output electrode and subsequent output electrodes (third output electrode, fourth output electrode,...) is disposed at a vacant odd number position among 2n if the output electrode has the same phase as that of the first output electrode, or at a vacant even number position among 2n if the output electrode has the same phase as that of the second output electrode.

As described above, if each input electrode and each output electrode are disposed in such a manner that a balanced signal is input to the input electrode and the signal is output as a balanced signal from the output electrode, then the MEMS resonator of the present invention can be made as a MEMS resonator of the 2n-th order (n is a natural number of 2 or larger). Since the oscillator of the higher order mode MEMS resonator becomes long, the oscillator can be processed with high accuracy. In forming a higher order mode MEMS resonator, it is necessary to determine the number of input electrodes and output electrodes by considering durability of the oscillator and its mount portion.

### [Seventh Embodiment]

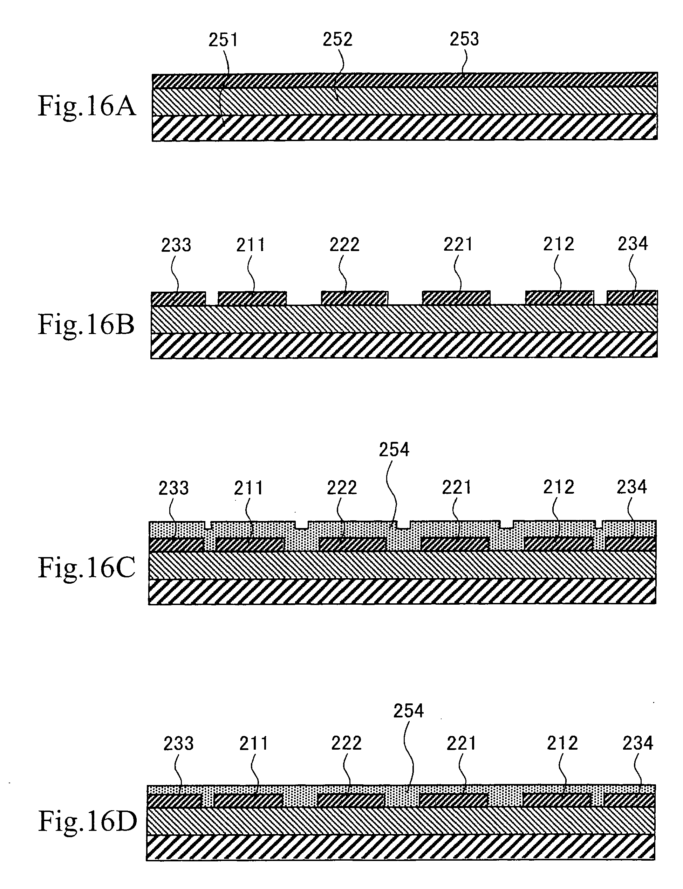

Next, an example of a manufacture method for the MEMS resonator 201 of the present invention will be described with reference to themanufactureprocess cross sectional views shown in Figs. 16A to 16H.

As shown in Fig. 16A, an insulating film 252 is formed on a semiconductor substrate 251. For example, the semiconductor substrate 251 is a silicon substrate and the insulating film 252 is a silicon nitride (SiN) film. The silicon nitride film has a thickness of, for example, 1 µm. Instead of the silicon nitride film, a laminated film of a silicon oxide film and a silicon nitride film may be used. In this manner, a substrate 210 is constituted of, for example, a silicon substrate as the semiconductor substrate 251 and the insulating film 252 formed on the semiconductor substrate. An electrode forming film 253 is formed on the insulating film 252. For example, the electrode forming film 253 is made of a polysilicon film and has a thickness of 0.5 µm.

Next, as shown in Fig. 16B, a resist mask for processing the electrode forming film 253 into the forms of the input electrodes and output electrodes is formed by resist coating and lithography techniques, and thereafter, by using the resist mask, the electrodes forming film 253 (refer to Fig. 16A) is etched to form the first input electrode 211, second output electrode 222, first output electrode 221 and second input electrode 212. At the same time, the oscillator electrodes 233 and 234 are formed from the electrode forming film 253 (refer to Fig. 16A). In this case, the first input electrode 211 and first output electrode 221 are disposed at such positions as the amplitude phases of the oscillator to be formed later at the positions of the first input electrode 211 and first output electrode 221 become the same phase, whereas the second input electrode 212 and second output electrode 222 are disposed at such positions as the amplitude phases of the oscillator to be formed later at the positions of the second input electrode 212 and second output electrode 222 become the same phase and different by 180° from the amplitude phase of the oscillator to be formed later at the position where the first input electrode 211 is formed. For example, the first input electrode 211, second output electrode 222, first output electrode 221 and second input electrode 212 are formed in this order. The oscillator electrodes 233 and 234 are formed sandwiching an electrode group including the first input electrode 211, second output electrode 222, first output electrode 221 and second input electrode 212, and being spaced from the electrode group. It is sufficient if the layout of the first and second input electrodes 211 and 212 and first and second output electrodes 221 and 222 allows a balanced input signal to be input to each input electrode and a balanced output signal to be output from each output electrode.

Next, as shown in Fig. 16C, a sacrificial layer 254 thicker than the first and second input electrodes 211 and 212 and first and second output electrodes 221 and 222 is formed covering the first input electrode 211, second output electrode 222, first output electrode 221, second input electrode 212 and oscillator electrode 234. For example, the sacrificial layer 254 is a silicon oxide film and has a thickness of 0.5 µm. It is sufficient if the sacrificial layer 254 is made of material which is selectively etched relative to the insulating film 252 and electrodes.

Next, as shown in Fig. 16D, the surface of the sacrificial layer 254 is planarized by chemical mechanical polishing. At this time, the sacrificial layer 254 is left thin on the first and second input electrodes 211 and 212 and first and second output electrodes 221 and 222. Since a thickness to be left determines a distance between an oscillator to be formed later and the first and second input electrodes 211 and 212 and first and second output electrodes 221 and 222, the sacrificial layer 254 corresponding to the distance is to be left. For example, the sacrificial layer 254 having a thickness of 0.1 µm is left on the first and second input electrodes 211 and 212 and first and second output electrodes 221 and 222. Similarly, the sacrificial layer 254 is also left on the electrodes 233 and 234.

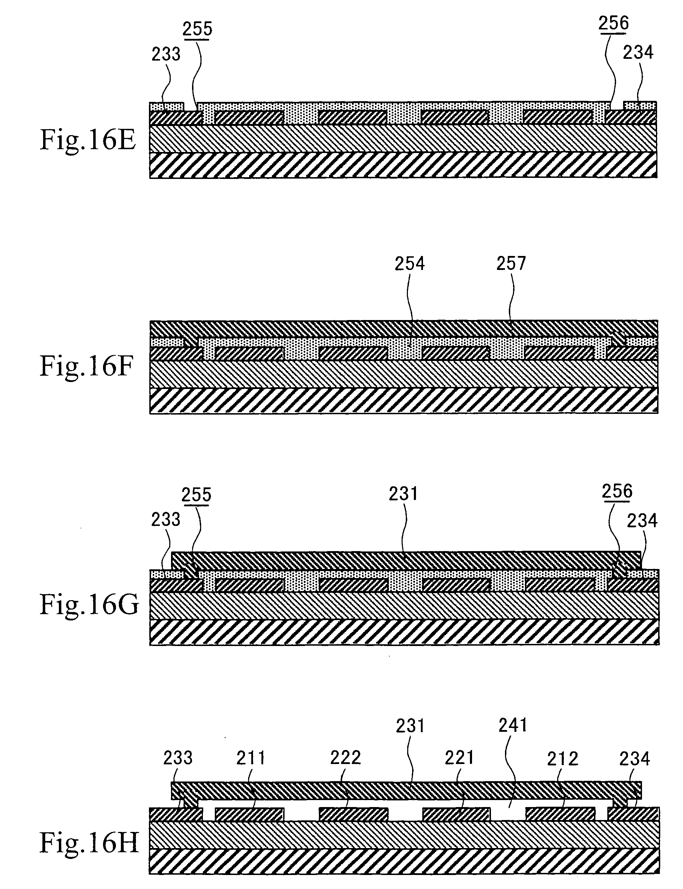

Next, as shown in Fig. 16E, an etching mask is formed by ordinary resist coating and lithograph techniques, and by using the etching mask, the sacrificial layer 254 is partially etched to form openings 255 and 256 exposing partial surfaces of the electrodes 233 and 234.

Next, as shown in Fig. 16F, an oscillator forming film 257 is formed on the whole surface of the sacrificial layer 254. For example, the oscillator forming film 257 is a polysilicon film and has a thickness of 0.5 µm.

Next, as shown in Fig. 16G, an etching mask is formed by ordinary resist coating and lithograph techniques, and by using the etching mask, the oscillator forming film 257 is etched to form a beam-like oscillator 231. The oscillator 231 is connected to the electrodes 233 and 234 via the openings 255 and 256.

Next, as shown in Fig. 16H, the sacrificial layer 254 (refer to Fig. 16G) is etched and removed by wet etching. Since the sacrificial layer 254 is made of silicon oxide in this example, hydrofluoric acid is used. Therefore, a space 241 is formed on both sides of each of the first input electrode 211, second output electrode 222, first output electrode 221 and second input electrodes 212, and between the oscillator 231 and the first input electrode 211, second output electrode 222, first output electrode 221 and second input electrodes 212. The space 241 has a distance of about 0.1 µm between the oscillator 231 and the first input electrode 211, second output electrode 222, first output electrode 221 and second input electrodes 212. In this manner, the MEMS resonator 201 is formed.

A method of forming each film by the above-described manufacture method may adopt CVD, sputtering, evaporation and the like. A thickness of each film is designed appropriately. If the uppermost surface of the insulating film 252 is made of silicon oxide and each electrode is made of polysilicon, the sacrificial layer 254 may be made of silicon nitride. In this case, hot phosphoric acid is used for wet-etching the sacrificial layer 254.

With the above-described manufacture method, the MEMS resonator 201 of the fourth-order mode capable of outputting balanced outputs from unbalanced inputs can be obtained.

### [Eighth Embodiment]

For a manufacture method for the MEMS resonator 202 of the present invention, in the MEMS resonator 201 manufacture method of the present invention described with reference to the manufacture process cross sectional views shown in Figs. 16A to 16H, the first input electrode 211 is used as the first input electrode, the second input electrode is formed at the position of the second output electrode 222, the first output electrode 221 is used as the first output electrode, and the second output electrode is formed at the position of the second input electrode 212. Other processes are similar to those of the manufacture method described in the sixth embodiment.

### [Ninth Embodiment]

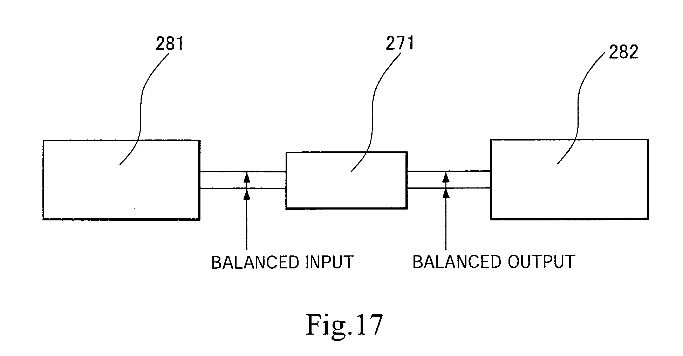

Next, with reference to the block diagram shown in Fig. 17, description will be made on an embodiment wherein the MEMS resonator 1 or MEMS resonator 2 is used as a frequency filter.

As described above, the MEMS resonator 201 of the present invention outputs a balanced output from a balanced input. Therefore, if the resonator 2 01 is used as the frequency filter, it is not necessary to use the balun device for changing unbalanced outputs to balanced outputs. More specifically, as shown in Fig. 17, by using the MEMS resonator 201 of the present invention as a frequency filter 271, output signals (balanced inputs) from a previous stage device (e.g., integrated circuit) 281 are output as balanced outputs. It is therefore possible to directly connect a subsequent stage device (e.g. , integrated circuit) 282 to the frequency filter 271.

Similar to the MEMS resonator 201, the MEMS resonators 202 and 203 can also be used as the frequency filter described with reference to Fig. 17.

In the fourth to ninth embodiments described above, each of the first input electrode 211, second input electrode 212, first output electrode 221, second output electrode 222, electrode 234 and the like may be made of metal instead of polysilicon. For example, the metal may use material used as metal wirings of a semiconductor device, such as aluminum, gold, copper and tungsten.

In the MEMS resonators of the fourth to sixth embodiments of the present invention, since the input electrodes inputting balanced inputs and the output electrodes outputting balanced outputs are provided, balanced inputs and balanced outputs are possible. Accordingly, the frequency filter, particularly an RF filter and an IF filter, using the MEMS resonator of the present invention does not require the balun device which is required for an RF filter or IF filter using a conventional beam type resonator. It is advantageous in that the circuit can be simplified and made compact at low cost.

In the manufacture method for the MEMS resonator of the seventh and eighth embodiments of the present invention descried above, the input and output electrodes are formed at the same time, the first and second input electrodes are formed as the input electrodes, the first and second output electrodes are formed as the output electrodes, the first input electrode and first output electrode are disposed in such a manner that the amplitude phases of the oscillator at positions of the first input electrode and first output electrode become the same phase, and the second input electrode and second output electrode are disposed in such a manner that the amplitude phases of the oscillator at positions of the second input electrode and second output electrode become the same phase and different by 180° from that of the oscillator at the position of the first input electrode. Accordingly, in the MEMS resonator, the balanced input to each input electrode can be output from each output electrode as the balanced output.

In the fourth to ninth embodiments, the object of outputting balanced outputs from balanced inputs is realized by disposing at the same phase the input electrode for inputting a balanced input signal and the output electrode for outputting a balanced output signal, without using the balun device. Industrial Applicability

The resonator and its driving method in microelectromechanical systems of the present invention are applicable to a frequency filter (RF filter, IF filter, etc.), an oscillator and the like.

## Claims

1. A MEMS resonator comprising:
an input electrode for inputting a signal;
an output electrode for outputting a signal; and
an oscillator facing the input electrode and the output electrodes via a space, and
the MEMS resonator **characterized in that** the output electrode has an electrode for outputting a balanced signal.

2. A MEMS resonator comprising:
an input electrode for inputting a signal;
an output electrode for outputting a signal; and
an oscillator facing the input electrode and the output electrode via a space,
the MEMS resonator **characterized in that** the output electrode has an electrode for inputting an unbalanced signal and outputting a balanced signal.

3. The MEMS resonator according to claim 2, **characterized in that**:
the output electrode includes a first output electrode and a second output electrode disposed, on one side of the input electrode and spaced apart from each other;
the first output electrode is disposed at a position having a phase different by 180° from a phase of the input electrode; and
the second output electrode is disposed at a position having a same phase as the phase of the input electrode.

4. The MEMS resonator according to claim 3, **characterized in that**:
the first output electrode is disposed on both sides of the second output electrode.

5. The MEMS resonator according to claim 2, **characterized in that**:
the output electrode includes a first output electrode and a second output electrode;
the input electrode includes a plurality of input electrodes;
the first output electrode is provided the same number as the number of the plurality of input electrodes, the first output electrodes and the plurality of input electrodes are disposed alternately, and at positions having phases different by 180° from a phase of each of the input electrodes; and
the second output electrode is disposedataposition opposite to the input electrode of the first output electrode disposed at a last end of a layout of the input electrodes and the first output electrodes, and at a position having a same phase as the phase of each of the input electrodes.

6. A MEMS resonator comprising:
an input electrode for inputting a signal;
an output electrode for outputting a signal; and
an oscillator facing the input electrode and the output electrode via a space,
the MEMS resonator in the microelectromechanical system **characterized in that**:
a balanced signal is input to the input electrode; and
a balanced signal is output from the output electrode.

7. The MEMS resonator according to claim 6, **characterized in that**:
the input electrode includes a first input electrode and a second input electrode;
the output electrode includes a first output electrode and a second output electrode;
the first input electrode and the first output electrode are disposed in such a manner that amplitude phases of the oscillator at positions of the first input electrode and the first output electrode become a same phase; and
the second input electrode and the second output electrode are disposed in such a manner that amplitude phases of the oscillator at positions of the second input electrode and the second output electrode become a same phase and different by 180° from the phase of the oscillator.

8. The MEMS resonator according to claim 7, **characterized in that**:
the first input electrode, the second output electrode, the first output electrode and the second input electrode are disposed in this order.

9. The MEMS resonator according to claim 7, **characterized in that**:
the first input electrode, the second input electrode, the first output electrode and the second output electrode are disposed in this order.

10. The MEMS resonator according to claim 6, **characterized in that**:
the input electrode includes a plurality of input electrodes;
the output electrode includes a plurality of output electrodes;
a first input electrode of the input electrodes and a first output electrode of the output electrodes are disposed in such a manner that amplitude phases of the oscillator at positions of the first input electrode and the first output electrode become a same phase;
a second input electrode of the input electrodes and a second output electrode of the output electrodes are disposed in such a manner that amplitude phases of the oscillator at positions of the second input electrode and the second output electrode become a same phase and different by 180° from the amplitude phases of the oscillator at a position of the first input electrode;
remaining input electrodes of the input electrodes are disposed in such a manner that the remaining input electrodes have a same phase as an amplitude phase of the oscillator at a position of the first input electrode or the second input electrode; and
remaining output electrodes of the output electrode are disposed in such a manner that the remaining output electrodes have a same phase as an amplitude phase of the oscillator at a position of the first output electrode or the second output electrode.

11. A driving method for a MEMS resonator , the MEMS resonator having:
an input electrode for inputting a signal;
an output electrode for outputting a signal; and
an oscillator facing the input electrode and the output electrode via a space,
the driving method for the MEMS resonator in the microelectromechanical system, **characterized by** comprising the step of inputting an unbalanced signal and outputting a balanced signal.

12. The driving method for a MEMS resonator according to claim 11, **characterized in that**:
the output electrode includes a first output electrode and a second output electrode, disposed on one side of the input electrode and spaced apart from each other;
the first output electrode is disposed at a position having a phase different by 180° from a phase of the input electrode; and
the second output electrode is disposed at a position having a same phase as the phase of the input electrode.

13. The driving method for a MEMS resonator according to claim 12, **characterized in that**:
the first output electrode is disposed on both sides of the second output electrode.

14. The driving method for a MEMS resonator according to claim 11, **characterized in that**:
the output electrode includes a first output electrode and a second output electrode;
the input electrode includes a plurality of input electrodes;
the first output electrode is provided the same number as the number of the plurality of input electrodes, the first output electrodes and the plurality of input electrodes are disposed alternately, and at positions having phases different by 180° from a phase of each of the input electrodes; and
the second output electrode is disposedataposition opposite to the input electrode of the first output electrode disposed at a last end of a layout of the input electrodes and the first output electrode, and at a position having a same phase as the phase of each of the input electrodes.

15. A frequency filter **characterized by** comprising a MEMS resonator , the MEMS resonator having:
an input electrode for inputting a signal;
an output electrode for an outputting signal; and
an oscillator facing the input electrode and the output electrode via a space,
the MEMS resonator in the microelectromechanical system **characterized in that** the output electrode has an electrode for inputting an unbalanced signal and outputting a balanced signal.

16. The frequency filter according to claim 15, **characterized in that**:
the output electrode includes a first output electrode and a second output electrode, disposed on one side of the input electrode and spaced apart from each other;
the first output electrode is disposed at a position having a phase different by 180° from a phase of the input electrode; and
the second output electrode is disposedat a position having a same phase as the phase of the input electrode.

17. A frequency filter comprising a MEMS resonator , the MEMS resonator having:
an input electrode for inputting a signal;
an output electrode for outputting a signal; and
an oscillator facing the input electrode and the output electrode via a space,
the frequency filter **characterized in that** a balanced signal is input to the input electrode and a balanced signal is output from the output electrode.

18. The frequency filter according to claim 17 , **characterized in that**:
the input electrode includes a first input electrode and a second input electrode;
the output electrode includes a first output electrode and a second output electrode;
the first input electrode and the first output electrode are disposed in such a manner that amplitude phases of the oscillator at positions of the first input electrode and the first output electrode become a same phase; and
the second input electrode and the second output electrode are disposed in such a manner that amplitude phases of the oscillator at positions of the second input electrode and the second output electrode become a same phase and different by 180° from the phase of the oscillator.

19. A manufacture method for a MEMS resonator , the MEMS resonator having:
an input electrode for inputting a signal;
an output electrode for outputting a signal; and
an oscillator facing the input electrode and the output electrode via a space,
the manufacture method **characterized by** comprising the steps of:
forming the input electrode and the output electrode at the same time;
forming a first input electrode and a second input electrode as the input electrodes;
forming a first output electrode and a second output electrode as the output electrodes;
disposing the first input electrode and the first output electrode in such a manner that amplitude phases of the oscillator at positions of the first input electrode and the first output electrode become a same phase; and
disposing the second input electrode and the second output electrode in such a manner that amplitude phases of the oscillator at positions of the second input electrode and the second output electrode become a same phase and different by 180° from the phase of the oscillator.
